# EUROPEAN PATENT SPECIFICATION

(11) **EP 4 177 615 B1**
(45) Date of publication and mention of the grant of the patent: **20.05.2026**
(21) Application number: 21207085.8
(22) Date of filing: 09.11.2021
(51) Int. Cl.: G01R 15/18, G01R 31/12

(54) **MONITORING DEVICE, ELECTRICAL INSTALLATION AND MONITORING METHOD**
ÜBERWACHUNGSVORRICHTUNG, ELEKTRISCHE INSTALLATION UND ÜBERWACHUNGSVERFAHREN
DISPOSITIF DE SURVEILLANCE, INSTALLATION ÉLECTRIQUE ET PROCÉDÉ DE SURVEILLANCE

(43) Date of publication of application: 10.05.2023
(73) Proprietor: HSP Hochspannungsgeräte GmbH, 53842 Troisdorf (DE)
(72) Inventor: Negri, Fabrizio, 90425 Nürnberg (DE); Natter, Beatrix, 82166 Gräfelfing (DE); Singh, Puneet Harminder, 90439 Nürnberg (DE)
(74) Representative: Betten & Resch

(56) References cited:
- WO-A1-2020/125090
- CN-A- 108 680 841
- KR-B1- 102 231 150
- US-A1- 2016 154 051
- NATHAN D JACOB ET AL: "On-line monitoring of partial discharges in a HVDC station environment", IEEE TRANSACTIONS ON DIELECTRICS AND ELECTRICAL INSULATION, IEEE SERVICE CENTER, PISCATAWAY, NJ, US, vol. 19, no. 3, 1 June 2012 (2012-06-01), pages 925 - 935, XP011447904, ISSN: 1070-9878, DOI: 10.1109/TDEI.2012.6215096
- JACOB N D ET AL: "Online partial discharge measurement of a high-voltage direct current converter wall-bushing", HIGH VOLTAGE ENGINEERING AND APPLICATION (ICHVE), 2010 INTERNATIONAL CONFERENCE ON, IEEE, PISCATAWAY, NJ, USA, 11 October 2010 (2010-10-11), pages 630 - 633, XP031804911, ISBN: 978-1-4244-8283-2
- MONTANARI GIAN CARLO ET AL: "A Smart Grid approach to condition based maintenance of renewable energy assets", 2014 SAUDI ARABIA SMART GRID CONFERENCE (SASG), IEEE, 14 December 2014 (2014-12-14), pages 1 - 7, XP033206661, DOI: 10.1109/SASG.2014.7274283
- ZHANG LU ET AL: "Study on Multi-parameter On-line Monitoring System for Transformer Bushing", 2020 ASIA ENERGY AND ELECTRICAL ENGINEERING SYMPOSIUM (AEEES), IEEE, 29 May 2020 (2020-05-29), pages 54 - 58, XP033783379, DOI: 10.1109/AEEES48850.2020.9121465

## Description

The present invention relates to a monitoring device for monitoring of an electrical installation comprising an electrical bushing, wherein said device comprises means for connecting said device to an output terminal of said bushing to receive a current and/or voltage output monitoring signal and is configured to measure a low-frequency signal component of said output signal to monitor a dissipation factor of said installation.

Electrical installations, like for example power transformers, are designed to have a lifetime of more than twenty years under standard conditions. During service, they may experience non-standard situations (also referred to as transients) which are reducing their lifetime and/or they are exposed to stresses which can trigger internal discharges on manufacturing defects (PDs).

A typical above-mentioned low-frequency monitoring device for a bushing has particularly the aim of measuring the relative bushing capacitance and the dissipation factor. The dissipation factor is understood to be a measure of loss-rate of energy of a mode of oscillation (mechanical, electrical, or electromechanical) in the bushing being a dissipative system.

The output terminal of the bushing usually is (or is a part of) a voltage or a test tap. The test tap can be also implemented by a voltage tap with integrated test tap functionality. A voltage tap is usually intended for use as a voltage divider during normal operation and may require the use of additional capacitance to limit the output voltage and protective devices e.g. mounted directly to the bushing. A test tap is intended for measurement of a dissipation factor, capacitance from conductor to tap, and partial discharge on the field. The test tap is moreover designed to allow the testing of the bushing in the factory, therefore being usually grounded. Since the capacitance from tap to ground is not controlled, the tap is not necessarily intended for use as a voltage divider during normal operation. When not in use, the voltage and test taps are usually effectively grounded.

A method for capacitance and dissipation measurement of high-voltage bushings for recording grid transients and partial discharge monitoring is described in the paper by Koch et al. "A New Method for On-Line Monitoring of Bushings and Partial Discharges of Power Transformers", IEEE 2012. The method proposed by Koch et al. comprises measurements in the UHF range for a sensitive partial discharge detection.

Nathan D Jacob et al describe in "On-line monitoring of partial discharges in a HVDC station environment", IEEE TRANSACTIONS ON DIELECTRICS AND ELECTRICAL INSULATION, 2012, the measurement of partial discharges in a transformer bushing at frequencies between 2.5-30 MHz.

The use of high-frequency transformers in the context of bushings is also known from the WO2020/125090, the US 2016/0154051 Al, CN 108 680 841 A.

JACOB N D ET AL: "Online partial discharge measurement of a high-voltage direct current converter wall-bushing", HIGH VOLTAGE ENGINEERING AND APPLICATION (ICHVE), 2010 INTERNATIONAL CONFERENCE ON, IEEE, PISCATAWAY, NJ, USA, 11 October 2010, pages 630-633, discloses an online PD measurement strategy for noise filtering and isolation of PD sources within the bushing.

The object of the present invention is to provide an aforementioned monitoring device which allows as reliable and cost efficient as possible monitoring of the electrical installation.

This object is achieved by a transformer control cubicle according to claim 1.

In accordance with the invention the transformer control cubicle comprises a monitoring device further comprising a high-frequency instrument transformer, particularly high-frequency current transformer, for measuring a high-frequency signal component of said output signal. Generally, a current transformer provides a secondary current that is accurately proportional to the current flowing in its primary windings. Current transformers are the current-sensing units of a power system and are widely used at generating stations, electrical substations, and in industrial and commercial electric power distribution. A high-frequency instrument transformer has a high rating of frequency, particularly above 1 kHz.

The present invention provides a non-invasive method for measuring the high-frequency signal component on bushings/transformers, e.g. by means of upgrading existing monitoring systems configured to evaluate the low-frequency component of the signals, without applying any additional hardware on the high-voltage area/level of the products.

Particularly, high-voltage bushings are considered as a main driver of a high-frequency information relevant for maintenance purposes. The state-of-the-art low-frequency monitoring (capacitance and dissipation factor monitoring) is not designed to separate the low-frequency and high-frequency components of the current that they monitor (the low frequency content is then measured from an elaborating microprocessor). The present invention proposes the addition of a high-frequency current transformer, e.g. at the input of a monitoring microprocessor, so that the high-frequency content of the signal can be then transferred to an additional module configured to digitalize it. In this way, the low-frequency monitoring is still easily possible, while the high-frequency monitoring becomes possible, without any system change on the high-voltage level (the integration gets done only on the low-voltage level, in a suitable transformer control cubicle). The proposed device allows an easier retrofitting than the state-of-the-art solutions. The measured raw data can be easily transmitted to a cloud-based environment where a neural network/fuzzy logic learning algorithm can elaborate them and provide an information about and/or a guidance on the maintenance activities to be done. Cloud applications can also be downloaded to an edge device which does the same elaboration on the level of the installation (e.g. a substation level).

By adding a high-frequency current transformer (HF CT), e.g. on the line cable measuring the bushing current, there is no need to replace existing plugs, and the upgrade work on the field is much easier as it involves just a material upgrade in a control cubicle (which is easier to access and does not require the cable re-commissioning). The output signal from the HF CT can then be connected to a dedicated signal/data processing device, e.g. a micro-controller, making the digital sampling and further transferring the data to a suitable communication device (which can for example be an IoT device).

According to the invention, said high-frequency transformer is configured for measuring a high-frequency signal component of a frequency in the range between 10 kHz and 200 kHz, in particular between 20 kHz and 100 kHz. Signal components within this frequency range are believed to be particularly relevant for partial discharge measurement.

The monitoring device may comprise a data processing monitoring unit (e.g. using a microprocessor) to receive and process a low-frequency signal component of the output signal.

According to an aspect of the invention said device comprises means for communication with an external, remote data processing system. The data processing system can be located far away from the electrical installation and the monitoring device (e.g. several kilometers). The data processing system can be part of the so-called cloud computing environment. The data processing system is configured to perform an analysis of the high-frequency signal component. A cloud computing is particularly advantageous because the processed data and measurements as well as the results of the data processing and computations are easily accessible to customers and system operators (e.g. even via a suitable mobile app or similar end user software).

The invention relates further to an electrical installation comprising an electrical bushing with an output terminal to provide a current and/or voltage output monitoring signal.

The object of the present invention is to provide such electrical installation as reliable as possible.

This object is achieved by an electrical installation according to claim 4.

According to an aspect of the invention, the electrical bushing is a high-voltage bushing, suitable for voltages above 1 kV, preferably voltages above 50 **kV.** Remote monitoring is particularly advantageous for this kind of applications/installations, since the on-site access to devices on these voltage levels is particularly difficult for safety reasons. The high-voltage bushing may comprise a voltage or test tap comprising said output terminal.

According to another aspect of the invention the installation comprises a high-voltage transformer, wherein a transformer winding of said transformer is connected with said high-voltage bushing to connect said winding to an external high-voltage line, in particular by feeding-through the corresponding high-voltage conductor through the grounded transformer housing.

The invention further relates to a method for monitoring of an electrical installation.

The object of the present invention is to provide such a method as cost effective and reliable as possible.

This object is achieved by a method according to claim 8. The method comprises the steps of providing a current and/or voltage output signal at an output terminal of the electrical bushing, receiving said output signal by a monitoring device comprising a high-frequency instrument transformer, and measuring a high-frequency signal component of said output signal by means of said high-frequency instrument transformer.

According to an embodiment of the invention the method comprises a trend analysis of the measured high-frequency signal component. In most applications, a trending analysis of the signal is appropriate to derive status information rather than an accurate amplitude analysis. Moreover, noise filtering and rejection methods can be used, e.g. using cloud computing, to enhance sensitivity to low amplitude signal components.

Preferably, the method further comprises a step of deriving a status or monitoring information about a status of said electrical installation using said high-frequency signal component and providing said information to an external receiver.

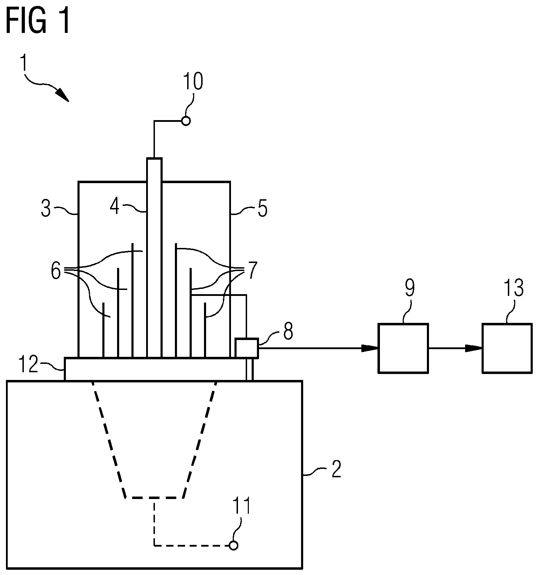

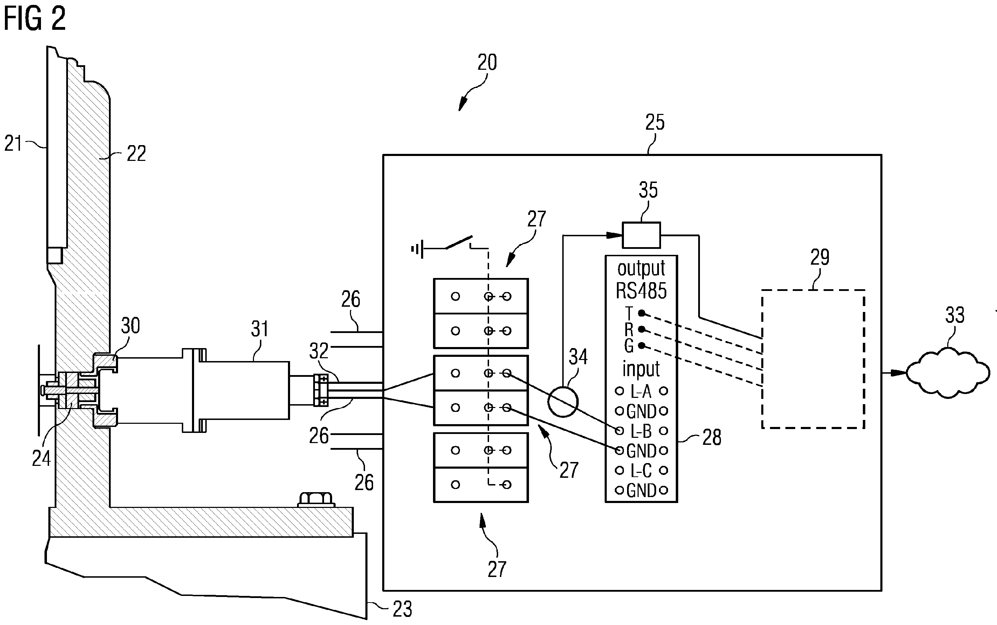

In the following the present invention is explained in more detail in accordance with embodiments shown in the figures 1 and 2.

Figures 1 and 2 schematically show embodiments of a monitoring device and an installation according to the invention.

Figure 1 shows an electrical installation 1 comprising a high-voltage transformer 2 with a high-voltage bushing 3. The bushing 3 comprises an inner conductor 4 extending along a longitudinal axis of the bushing **3,** an insulating body 5 that surrounds the inner conductor 4 along its longitudinal direction. The insulating body 5 comprises insulating layers 6 configured from a synthetic material or paper that is impregnated with a resin, an ester, oil or other insulating organic material, and electrically conductive control inserts 7 for field control being spaced apart from one another by means of the insulating layers 6 and arranged substantially concentrically (coaxially) around the inner conductor 4.

The bushing 3 further comprises a test tap or voltage tap 8 connected to one of the control inserts 7 and mounted on a bushing flange 12. The test or voltage tap 8 allows a measurement of a current or voltage signal for online monitoring of the installation 1. The monitoring signal is transmitted to a monitoring device 9 located in a separate cubicle. At its upper end the bushing 3 comprises a terminal 10 to connect to a high-voltage line. At its lower connecting end the bushing is connected with a winding 11 of the transformer 2. The monitoring device 9 is configured to transmit a data provided at its output to a remote data processing system 13.

Figure 2 shows an electrical installation 20 comprising a high-voltage bushing 21. The bushing 21 has a bushing flange 22 configured to mount the bushing 21 on a housing of a high-voltage transformer 23. The bushing 21 further comprises a test or voltage tap 24, which allows a measurement of corresponding monitoring voltage and/or current signal for measuring a relative bushing capacitance and dissipation factor.

For monitoring and control purposes the installation 20 comprises a monitoring device 25. The monitoring device 25 comprises a plurality of input terminals 26, disconnector switches 27, a data processing monitoring unit 28 (including an appropriate microprocessor) and an IoT device 29.

The data processing monitoring unit 28 is connected with the test tap 24 via an adapter 30, a suitable plug 31, a coax cable 32, one of the input terminals 26 and one of the disconnector switches 27 using appropriate interfaces and cables. In general, the length of the cable 32 does not exceed 30 m. The data processing monitoring unit 28 is configured to receive and process a low-frequency component (up to 1 kHz) of the measured signal. The IoT device 29 is configured to receive output data from the data processing monitoring unit 28 and to exchange data with other devices and systems over the internet or another communications network. The measured raw data (the current/voltage signal measured via the test tap) is transmitted via the data processing monitoring unit 28 and the IoT device 29 to a cloud-based environment 33 (particularly a data processing system located in the "cloud") where the data is analyzed by an appropriate learning algorithm and a guidance on necessary maintenance activities is provided. The monitoring device 25 further comprises a high-frequency current transformer (HV CT) 34 at the input of the monitoring module, so that the high-frequency component of the monitoring signal can be then transferred to a data processing unit 35 configured to perform a digital sampling of the data and to transfer the processed data to the IoT device 29 as well.

The monitoring device and the HV CT are easily included in a transformer control cubicle. Positioning of the current sensor (the HV CT) within the control cubicle makes a retrofit of existing installations much easier than compared to current state-of-the-art solutions (where the retrofit involves i.a. an exchange of material.

## Claims

1. A transformer control cubicle comprising a monitoring device (9, 25) for monitoring of an electrical installation (1, 20) comprising an electrical bushing (3, 21), wherein said device (9, 25) comprises:
means for connecting said device (9, 25) to an output terminal (8, 24) of said bushing (3, 21) to receive a current and/or voltage output signal and is configured to measure a low-frequency signal component of said output signal to monitor a dissipation factor of said installation (1, 20); and
wherein said device (9, 25) further comprises a high-frequency instrument transformer (34) for measuring a high-frequency signal component of said output signal, wherein said high-frequency transformer (34) is configured for measuring a high-frequency signal component of a frequency in the range between 10 kHz and 200 kHz.

2. Transformer control cubicle according to claim 1,
wherein said device (9, 25) comprises a data processing monitoring unit (28) to receive and process the low-frequency signal component of said output signal, and optionally wherein said device (9, 25) comprises the high-frequency instrument transformer (34) at an input of the data processing monitoring unit (28).

3. Transformer control cubicle according to any of the preceding claims, wherein said device (9, 25) comprises means (29) for communication with an external data processing system (13, 33).

4. Electrical installation (1, 20) comprising an electrical bushing (3, 21) with an output terminal (8, 24) to provide a current and/or voltage output monitoring signal and a transformer control cubicle according to any of the preceding claims.

5. Electrical installation (1, 20) according to claim 4, wherein said electrical bushing (3, 21) is a high-voltage bushing.

6. Electrical installation (1, 20) according to claim 5, wherein said high-voltage bushing (3, 21) comprises a voltage or test tap comprising said output terminal (8, 24).

7. Electrical installation (1, 20) according to claims 4 to 6, wherein said installation comprises a high-voltage transformer (2), wherein a transformer winding (11) of said transformer (2) is connected with said high-voltage bushing (3, 21) to connect said winding (11) to an external high-voltage line (10).

8. Monitoring method for an electrical installation (1, 20) according to claims 4 to 7, comprising the steps of
- providing a current and/or voltage output signal at an output terminal (8, 24) of the electrical bushing (3, 21),
- receiving said output signal by a monitoring device (9, 25) comprising a high-frequency instrument transformer (35),
- measuring a high-frequency signal component of a frequency in the range between 10 kHz and 200 kHz of said output signal using said high-frequency instrument transformer (35).

9. Method according to claim 8, wherein said method comprises a trend analysis of the measured high-frequency signal component.

10. Method according to claim 8 or 9, wherein said method comprises a step of deriving a status or monitoring information about a status of said electrical installation using said high-frequency signal component and providing said information to an external receiver.

## Patentansprüche

1. Ein Transformatorsteuerschrank, umfassend eine Überwachungsvorrichtung (9, 25) zur Überwachung einer elektrischen Anlage (1, 20), die eine elektrische Durchführung (3, 21) umfasst, wobei die besagte Vorrichtung (9, 25) Folgendes umfasst:
Mittel zum Verbinden der besagten Vorrichtung (9, 25) mit einem Ausgangsanschluss (8, 24) der besagten Durchführung (3, 21), um ein Strom- und/oder Spannungsausgangssignal zu empfangen, und dazu konfiguriert ist, eine Niederfrequenz-Signalkomponente des besagten Ausgangssignals zu messen, um einen Verlustfaktor der besagten Anlage (1, 20) zu überwachen;
und wobei die besagte Vorrichtung (9, 25) ferner einen Hochfrequenz-Messwandler (34) zum Messen einer Hochfrequenz-Signalkomponente des besagten Ausgangssignals umfasst, wobei der besagte Hochfrequenz-Messwandler (34) zum Messen einer Hochfrequenz-Signalkomponente mit einer Frequenz im Bereich zwischen 10 kHz und 200 kHz konfiguriert ist.

2. Transformatorsteuerschrank nach Anspruch 1, wobei die besagte Vorrichtung (9, 25) eine Datenverarbeitungs-Überwachungseinheit (28) umfasst, um die Niederfrequenz-Signalkomponente des besagten Ausgangssignals zu empfangen und zu verarbeiten, und wobei die besagte Vorrichtung (9, 25) optional den Hochfrequenz-Messwandler (34) an einem Eingang der Datenverarbeitungs-Überwachungseinheit (28) umfasst.

3. Transformatorsteuerschrank nach einem der vorhergehenden Ansprüche, wobei die besagte Vorrichtung (9, 25) Mittel (29) zur Kommunikation mit einem externen Datenverarbeitungssystem (13, 33) umfasst.

4. Elektrische Anlage (1, 20), umfassend eine elektrische Durchführung (3, 21) mit einem Ausgangsanschluss (8, 24) zur Bereitstellung eines Strom- und/oder Spannungsausgangsüberwachungssignals, und einen Transformatorsteuerschrank nach einem der vorhergehenden Ansprüche.

5. Elektrische Anlage (1, 20) nach Anspruch 4, wobei die besagte elektrische Durchführung (3, 21) eine Hochspannungsdurchführung ist.

6. Elektrische Anlage (1, 20) nach Anspruch 5, wobei die besagte Hochspannungsdurchführung (3, 21) einen Spannungs- oder Prüfabgriff umfasst, der den besagten Ausgangsanschluss (8, 24) umfasst.

7. Elektrische Anlage (1, 20) nach den Ansprüchen 4 bis 6, wobei die besagte Anlage einen Hochspannungstransformator (2) umfasst, wobei eine Transformatorwicklung (11) des besagten Transformators (2) mit der besagten Hochspannungsdurchführung (3, 21) verbunden ist, um die besagte Wicklung (11) mit einer externen Hochspannungsleitung (10) zu verbinden.

8. Überwachungsverfahren für eine elektrische Anlage (1, 20) nach den Ansprüchen 4 bis 7, das die folgenden Schritte umfasst:
• Bereitstellen eines Strom- und/oder Spannungsausgangssignals an einem Ausgangsanschluss (8, 24) der elektrischen Durchführung (3, 21),
• Empfangen des besagten Ausgangssignals durch eine Überwachungsvorrichtung (9, 25), die einen Hochfrequenz-Messwandler (35) umfasst,
• Messen einer Hochfrequenz-Signalkomponente mit einer Frequenz im Bereich zwischen 10 kHz und 200 kHz des besagten Ausgangssignals unter Verwendung des besagten Hochfrequenz-Messwandlers (35).

9. Verfahren nach Anspruch 8, wobei das besagte Verfahren eine Trendanalyse der gemessenen Hochfrequenz-Signalkomponente umfasst.

10. Verfahren nach Anspruch 8 oder 9, wobei das besagte Verfahren einen Schritt des Ableitens einer Status- oder Überwachungsinformation über einen Status der besagten elektrischen Anlage unter Verwendung der besagten Hochfrequenz-Signalkomponente und des Bereitstellens der besagten Information an einen externen Empfänger umfasst.

## Revendications

1. Une armoire de commande de transformateur, comprenant un dispositif de surveillance (9, 25) destiné à surveiller une installation électrique (1, 20) comprenant une traversée électrique (3, 21), ledit dispositif (9, 25) comprenant :
des moyens pour connecter ledit dispositif (9, 25) à une borne de sortie (8, 24) de ladite traversée (3, 21) afin de recevoir un signal de sortie de courant et/ou de tension, et est configuré pour mesurer une composante de signal à basse fréquence dudit signal de sortie afin de surveiller un facteur de dissipation de ladite installation (1, 20) ; et
ledit dispositif (9, 25) comprenant en outre un transformateur (34) de mesure haute fréquence, destiné à mesurer une composante de signal haute fréquence dudit signal de sortie, ledit transformateur haute fréquence (34) étant configuré pour mesurer une composante de signal haute fréquence d'une fréquence comprise dans une plage allant de 10 kHz à 200 kHz.

2. Armoire de commande de transformateur selon la revendication 1, dans laquelle ledit dispositif (9, 25) comprend une unité (28) de surveillance de traitement de données, destinée à recevoir et à traiter la composante de signal basse fréquence dudit signal de sortie, et dans laquelle, optionnellement, ledit dispositif (9, 25) comprend le transformateur (34) de mesure haute fréquence à une entrée de l'unité (28) de surveillance de traitement de données.

3. Armoire de commande de transformateur selon l'une quelconque des revendications précédentes, dans laquelle ledit dispositif (9, 25) comprend des moyens (29) de communication avec un système (13, 33) de traitement de données externe.

4. Installation électrique (1, 20) comprenant une traversée électrique (3, 21) avec une borne de sortie (8, 24) pour fournir un signal de surveillance de sortie de courant et/ou de tension et une armoire de commande de transformateur selon l'une quelconque des revendications précédentes.

5. Installation électrique (1, 20) selon la revendication 4, dans laquelle ladite traversée électrique (3, 21) est une traversée haute tension.

6. Installation électrique (1, 20) selon la revendication 5, dans laquelle ladite traversée haute tension (3, 21) comprend une prise de tension ou de test comprenant ladite borne de sortie (8, 24).

7. Installation électrique (1, 20) selon les revendications 4 à 6, dans laquelle ladite installation comprend un transformateur haute tension (2), dans laquelle un enroulement (11) dudit transformateur (2) est relié à ladite traversée haute tension (3, 21) afin de relier ledit enroulement (11) à une ligne haute tension externe (10).

8. Procédé de surveillance d'une installation électrique (1, 20) selon les revendications 4 à 7, comprenant les étapes suivantes
- fournir un signal de sortie de courant et/ou de tension au niveau d'une borne de sortie (8, 24) de la traversée électrique (3, 21),
- recevoir ledit signal de sortie par un dispositif de surveillance (9, 25) comprenant un transformateur de mesure haute fréquence (35),
- mesurer une composante de signal haute fréquence d'une fréquence comprise entre 10 kHz et 200 kHz dudit signal de sortie au moyen dudit transformateur de mesure haute fréquence (35).

9. Procédé selon la revendication 8, dans lequel ledit procédé comprend une analyse de tendance de la composante de signal haute fréquence mesurée.

10. Procédé selon la revendication 8 ou la revendication 9, dans lequel ledit procédé comprend une étape consistant à déduire des informations d'état ou de surveillance concernant un état de ladite installation électrique au moyen de ladite composante de signal haute fréquence et à fournir lesdites informations à un récepteur externe.
